# EUROPEAN PATENT APPLICATION

(11) **EP 0 757 374 A1**
(43) Date of publication of application: **05.02.1997**
(21) Application number: 96301074.9
(22) Date of filing: 16.02.1996
(51) Int. Cl.: H01J 37/32

(54) **Etching electrode and manufacturing process thereof**

(30) Priority: 31.07.1995 JP 195389/95
(71) Applicant: KABUSHIKI KAISHA KOBE SEIKO SHO also known as Kobe Steel Ltd., Kobe 651 (JP)
(72) Inventor: Nozawa, Toshihisa, Nishi-ku, Kobe-shi, Hyogo, 651-22 (JP); Kitamura, Toshiaki, Chuo-ku, Kobe-shi, Hyogo, 651 (JP); Kawai, Akihiro, Chuo-ku, Kobe-shi, Hyogo, 651 (JP); Nishizawa, Takashi, Nishi-ku, Kobe-shi, Hyogo, 651-22 (JP); Muramatsu, Kazuo, Chuo-ku, Kobe-shi, Hyogo, 651 (JP); Suzuki, Tetsuo, Nishi-ku, Kobe-shi, Hyogo, 651-22 (JP); Takada, Shunsuke, Chuo-ku, Kobe-shi, Hyogo, 651 (JP)
(74) Representative: Lewin, John Harvey

(57) **Abstract**

An inexpensive etching electrode having a much longer service life than glass type carbon is provided. An etching electrode made from high hardness carbon comprising a highly dense crystallized structure with an apparent density of 1.7 times or more.

## Description

### BACKGROUND OF THE INVENTION

### Field of the Invention

This invention relates to an etching electrode used in electrode plates and the like of plasma etching equipment and a manufacturing process thereof.

### Description of the Related Art

An ever higher level of integration is demanded of semiconductor devices due to increased demands for more compact equipment and for greater storage of information. To meet these demands, the circuits formed on the wafer have become more and more minute. A basic condition for attaining yet higher levels of circuit integration is raw material possessing a high degree of purity so extreme measures must be taken to prevent contamination from impurities during the production process. Therefore it is also essential that the components comprising the production equipment emit no impurities.

Plasma etching equipment is widely used in the manufacture of semiconductor devices such as super LSI (large scale integration) devices. This plasma etching equipment forms circuits on the silicon wafer by means of dry etching of the polysilicon and oxidized films or metallic films such as aluminum.

The parallel planar type plasma etching equipment is often used. This type applies radio frequency electrical power between two electrodes facing each other from above and below. The wafer placed atop the lower electrode is etched by means of the gas plasma thus generated. This electrode must be highly pure, conductive and chemically stable.

Highly pure graphite material was used in past years for this electrode but during etching, desorption of the filler material powder occurred causing destruction of the circuit pattern.

In view of the above, in recent years glass-like carbon has come to be utilized as shown in Japanese Patent Laid-open No. Sho 62-252942 and Japanese Patent Laid-open No. Hei 5-320955. This glass-like carbon has less particle emission compared with the above graphite material. The reason for this is that graphite has relatively large crystalline domains with large empty spaces and is soft. Glass-like carbon on the other hand contains closed pores of relatively small size, and has random orientation of graphite hexagonal plane. In other words, it is a highly strong and hard, carbon material, provided with isotropic structures with the advantage of being resistant to particle desorption.

A further advantage of glass-like carbon is that it can be highly purified by causing the glass-like carbon to react with halogen gas at high temperatures of 2000°C or more. This high degree of purification makes glass-like carbon a suitable material for maintaining clean room conditions required in semiconductor manufacturing processes.

Silicon has also been proposed as another electrode material. The silicon electrode has even lower particle emission than the glass-like carbon electrode. Although silicon has even lower particle desorption, it has higher elossion rate compared with glass-like carbon.

Silicon electrode has a price five or six times higher than that of an electrode made of carbon material, making it difficult to reduce costs in semiconductor device products.

Glass-like carbon on the other hand, though actually used in electrodes for plasma etching and having a fine structure is basically a porous material so that as operating time increases, the surface gradually wears away and after about 150 hours starts to emit carbon particles. As this process continues the glass-like carbon electrode eventually becomes totally unusable. An additional problem is that during etching, a large amounts of material deposit and pile up on the electrode. Frequent removal of this material increases the etching material down time reducing operating rate efficiency.

### SUMMARY OF THE INVENTION

In view of the foregoing, it is the object of this invention to provide an etching electrode that is stable, has a longer service life and virtually no particle emissions; and a manufacturing method thereof.

The essential feature of the etching electrode of this invention is that it is made of hard carbon having a fine, highly dense crystalline structure with an apparent density of 1.7 or more.

The essential feature of the manufacturing method is that it utilizes heat treatment of thermosetting resin and further densification for manufacturing the carbon electrode, followed by subjecting the heat treated resin to hot isotatic processing (HIP) at 800 atmospheres or more and a temperature of 2100°C or more.

The manufacture of the etching electrode is in particular, preferably performed by carbonizing thermosetting resin at 1000 to 1800°C to obtain a heat treated product, performing hot isotatic processing (HIP) at 800 atmospheres or more and a temperature of 2100°C or more, and then continually dispensing halogen gas during heating to temperatures of 2000°C or more in treatment to obtain a high density and high degree of purity.

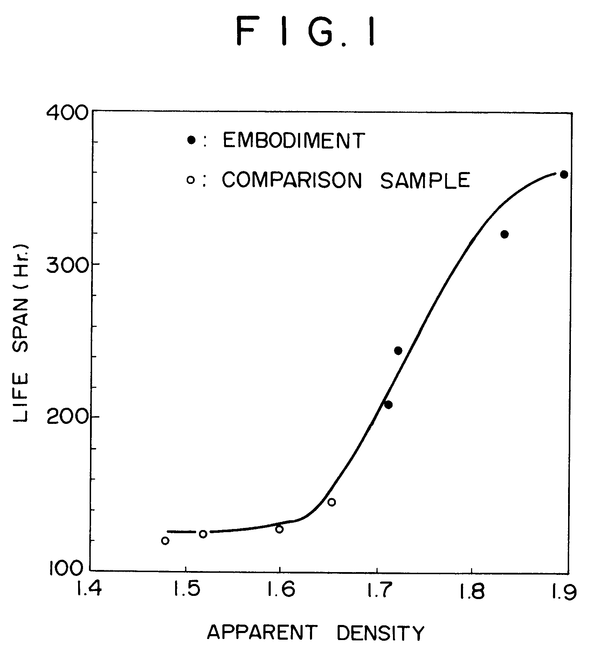

The inventors found that the life span of the etching electrode is largely dependent on the apparent density and applied that idea to this invention. In other words, at an apparent density region of 1.6 or less no significant correlation is found between apparent density and life span of the electrode. However as the apparent density is raised, the correlation appears and life span of the electrode was found to extend remarkably on exceeding an apparent density around 1.6 to 1.7. (See Fig. 1. Details will be described later.)

The hard carbon as referred to in this invention is a carbon having a highly dense, fine crystalline domain with an apparent density of 1.7 or more. The description of this invention is not limited to merely hardness. The hard carbon crystal structure of this invention is relatively small with clusters of fine crystals gathered together in random directions, unlike the clusters of crystals of graphite, which are relatively large.

In contrast to conventional glass-like carbon which has numerous pores in the fine crystal structure, hard carbon with its larger apparent density of 1.7 is an extremely dense material having a greatly reduced number of pores. Accordingly hard carbon shows very satisfactory wear resistance and virtually no particle emissions, making it a superlative material for etching electrodes.

Conventional glass-like carbon has a relatively low density and an apparent density of about 1.5. The numerous pores in the material make it prone to emit carbon particles during use and are a cause in reducing the life span of this electrode. The hard carbon of this invention however has a much smaller particle emission than glass-like carbon.

The hard carbon with an apparent density of 1.7 or more as described above, can be produced by incorporating HIP treatment into the manufacturing process. This HIP treatment disperses and blows out the inner pores (air spaces) in the material to obtain the hard material of this invention.

The material for the hard carbon is preferably a molded block of thermosetting resin not containing fillers of graphite powder, carbon powder, graphite fibers or carbon fibers etc. This resin is then heat treated in an inert atmosphere and next subjected to HIP treatment to obtain hard carbon with an apparent density of 1.7 or more.

The previously mentioned temperature of 2100°C and 800 atmospheres are sufficient as a condition for HIP treatment. When less than 2100°C or 800 atmospheres, an apparent density of 1.7 or more cannot be obtained.

The temperature for carbonization in the manufacturing method of this invention is described next. A heat treatment temperature of less than 1000°C results in insufficient carbonization with large amounts of residual hydrogen still present. When HIP treatment is performed in this state, hydrogen is suddenly emitted during the HIP treatment and the heat treated product cracks from the inside. Further, when HIP treatment is performed with large amounts of residual hydrogen present, the temperature rises during the HIP treatment and before the pores can be eliminated, graphite is deposited inside them by means of a chemical vapor reaction. Therefore, after the HIP treatment, graphite is present within the carbon. This graphite drastically reduces the life span of the electrode. Therefore a lower temperature limit of 1000°C was set for carbonization.

On the other hand, when heat treatment is performed at temperatures in excess of 1800°C, the density is not improved after HIP treatment due to growth of graphite structures within minute areas. Therefore an upper temperature limit of 1800°C was set for carbonization.

The etching electrode of this invention as described above, has virtually no particle emissions and an extremely long life span. In addition, the carbon which comprises the material of the electrode is inexpensive and the long life span of the electrode makes frequent replacement unnecessary so that a large reduction in the cost of semiconductor devices can be achieved.

### BRIEF DESCRIPTION OF THE DRAWINGS

The aforesaid and other objects and features of the present invention will become more apparent from the following detailed description and the accompanying drawings.
Figure 1 is a graph showing the apparent density versus life span of the electrode.

### DESCRIPTION OF THE PREFERRED EMBODIMENTS

The thermosetting resin was placed in a hot press and heat molded to form a disk shaped mold with an outer diameter of 250mm and a thickness of 4mm. Eight hundred through holes each 1.0mm in diameter were drilled in the center of the mold body, and installation screw holes were drilled in the outer circumference. After the above machining was complete, the mold body was interposed between two graphite spacers and heat treated in an electric furnace under the temperature conditions in Table 1 while nitrogen gas was made to flow in the electric furnace.

The embodiments 1 through 4 and the comparison samples 1 and 2 were placed in a crucible after the forming of the mold bodies and HIP treatment performed under the conditions shown in Table 1. HIP treatment was not performed on the comparison samples 3 and 4.

The comparison sample 3 and 4 mold bodies, along with the HIP treated mold bodies were heated to 2200°C in a halogen gas atmosphere and processed to a high level of purity. The embodiments 1 through 4 obtained in the manner were mold bodies of hard carbon with a high level of purity.

The carbon of the embodiments and comparison samples thus obtained were next subjected to primary grinding by a large dual surface grinder using #800 SiC abrasive. This was followed by secondary grinding using #6000 SiC abrasive to obtain a smooth surface and form an etching electrode dia. 210mm x 3.5 tmm thick.

**Table 1**

| | Heat treated temperature (C°) | HIP treatment conditions | | Apparent Density |
|---|---|---|---|---|
| | | Temperature (C°) | Pressure (atm) | |
| Comparison Sample 1 | 1200 | 2000 | 2000 | 1.60 |
| Embodiment 1 | 1200 | 2200 | 2000 | 1.71 |
| Embodiment 2 | 1200 | 2500 | 2000 | 1.83 |
| Comparison Sample 2 | 1200 | 2500 | 500 | 1.65 |
| Embodiment 3 | 1200 | 2500 | 1000 | 1.72 |
| Embodiment 4 | 1200 | 2800 | 2000 | 1.89 |
| Comparison Sample 3 | 1200 | - | - | 1.52 |
| Comparison Sample 4 | 2500 | - | - | 1.48 |

The etching electrodes for the embodiments 1 through 4, and the comparison samples 1 through 4 obtained as described above were respectively used as the upper electrode in the parallel planar type plasma etching equipment. A radio frequency of 13.56 MHz at 650 watts was applied to these electrodes. Etching of the silicon wafer was performed while a gas mixture of CF₄ at 50sccm (Standard Cubic cm), CHF₃ at 50 sccm and Ar at 1000 sccm was dispensed, and the life span of these etching electrodes measured. Life span of the electrode was determined from the point at which the electrodes emitted particles. Those results are shown in Fig.1.

Table 2 shows the characteristics of the hard carbon material of the embodiment 2, conventional glass-like carbon equivalent to the comparison samples 3 & 4, and artificial graphite.

**Table 2**

| | Embodiment 2 | Glass-like carbon | | Artificial graphite |
|---|---|---|---|---|
| | | Comparison sample 3 | Comparison Sample 4 | |
| Apparent density | 1.83 | 1.52 | 1.48 | 1.5∼1.8 |
| Hardness (shore) | 125 | 100∼110 | 70∼80 | 30∼40 |
| Bending strength (kgf/cm²) | 2700 | 1000∼1200 | 500∼600 | 700∼1000 |
| Resistance (Ω-cm) | 4.5x10⁻³ | 4.0∼4.5x10⁻³ | 3.5∼4.0x10⁻³ | 0.8∼1.2x10⁻³ |
| Coefficient of thermal expansion (1/°C) | 3x10⁻⁶ | 2.0∼2.2x10⁻⁶ | 2.0∼2.2x10⁻⁶ | 2.0∼3.0x10⁻⁶ |
| Coefficient of heat propagation (kcal/m.Hr.·°C) | 10 | 7∼8 | 13∼15 | 100∼130 |
| Life span (Hr.) | 350 | 150 | 120 | 50 |

Measurement of apparent density was performed by the solvent exchange method and utilizing the AUTOTRUEDENCER (manufactured by Shimadzu Corp.) after drying the test samples for 5 hours at 120°C.

A marked elongation in life span can be seen near the apparent density region of 1.6 through 1.7 as shown in Fig. 1. In contrast to the comparison sample, the life span of the embodiment with a large apparent density of 1.7 or more has become very long.

As can be seen in Table 2, the comparison samples 3 and 4 made of conventional glass-like carbon have an apparent density below 1.60 and and low density with a high pore rate and an extremely large number of air gaps (pores) within the fine crystal structure. Thus the life span of the comparison samples 3 and 4 as an etching electrode material is extremely short. In contrast, the embodiment 2 has a high apparent density and a long life span.

## Claims

1. An etching electrode comprised of hard carbon and having a highly dense crystalline structure with an apparent density of 1.7 or more.

2. A manufacturing process for the etching electrode according to claim 1 utilizing heat treatment of thermosetting resin in an inert atmosphere and treatment to attain a further high degree of purity in the carbon-based electrode in a method, wherein hot isostatic processing (HIP) is performed at 800 atmospheres or more and a temperature of 2100°C or more.

3. A manufacturing process for the etching electrode according to claim 2 utilizing heat treatment of thermosetting resin at 1000 to 1800°C to obtain a carbonized product, said heat treated product is subjected to hot isotatic processing (HIP) at 800 atmospheres or more at a temperature of 2100°C or more and, said HIP treated product is subjected to purification treatment at a temperature of 2000°C or more in a halogen gas atmosphere.
